# EUROPEAN PATENT APPLICATION

(11) **EP 4 195 240 A1**
(43) Date of publication of application: **14.06.2023**
(21) Application number: 21214050.3
(22) Date of filing: 13.12.2021
(51) Int. Cl.: H01L 21/50, H01L 23/053, H01L 23/10, H01L 23/24, H01L 25/07, H01L 21/54

(54) **A METHOD FOR FABRICATING A SEMICONDUCTOR DEVICE MODULE BY USING A REACTIVE TAPE AND A SEMICONDUCTOR DEVICE MODULE**

(71) Applicant: Infineon Technologies AG, 85579 Neubiberg (DE)
(72) Inventor: HERZER, Anita, 67655 Kaiserslautern (DE)
(74) Representative: Lambsdorff & Lange Patentanwälte Partnerschaft mbB

(57) **Abstract**

A method (100) for fabricating a semiconductor device module comprises providing a substrate comprising one or more semiconductor dies disposed thereon (110), providing a housing (120), applying a reactive tape on partial surfaces of one or both of the substrate and the housing (130), mounting the housing onto the substrate (140), filling in a potting material into the interior of the housing (150), and curing the potting material and the reactive tape (160).

## Description

### TECHNICAL FIELD

The present disclosure is related to a method for fabricating a semiconductor device module and to a semiconductor device module.

### BACKGROUND

Semiconductor device modules or packages are fabricated by using different sorts of materials among them different sorts of glues, potting materials, or encapsulants. In many cases of fabricating a semiconductor device module a substrate and a housing are provided wherein the substrate comprises one or more semiconductor dies disposed thereon. In some of these cases the housing has to be attached to the substrate by a glue and a potting material has to be filled into the housing. After filling in the potting material both the glue and the potting material can be cured by a temperature process.

When a new semiconductor module is to be developed, it may be desirable for various reasons to use a different potting material than the one used in previous versions of the semiconductor module, but not to change the adhesive material. Then one problem may arise that the new potting material cures at a lower temperature than the previously used potting material with the consequence that during the temperature process it starts to press against the still uncured, viscous glue and may lead to leaking potting material out of the housing.

For these and other reasons there is a need for the present disclosure.

### SUMMARY

A first aspect of the present disclosure is related to a method for fabricating a semiconductor device module, the method comprising providing a substrate comprising one or more semiconductor dies disposed thereon, providing a housing, applying a reactive tape on partial surfaces of one or both of the substrate and the housing, mounting the housing onto the substrate, filling in a potting material into the interior of the housing, and curing the potting material and the reactive tape.

A second aspect of the present disclosure is related to a semiconductor device module, comprising a substrate comprising one or more semiconductor dies disposed thereon, a housing mounted on the substrate, an adhesive layer disposed between partial surfaces of the substrate and the housing, wherein the adhesive layer is fabricated by applying a reactive tape on the partial surfaces and curing the reactive tape, and a potting material filled into the interior of the housing.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a flow diagram for illustrating a method for fabricating a semiconductor device module.
Fig. 2 shows a perspective view on a semiconductor device module in an intermediate state of the fabrication.
Fig. 3 shows a cross-sectional side view of a reactive tape.
Fig. 4 shows a cross-sectional side view of a semiconductor device module after finishing the fabrication.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

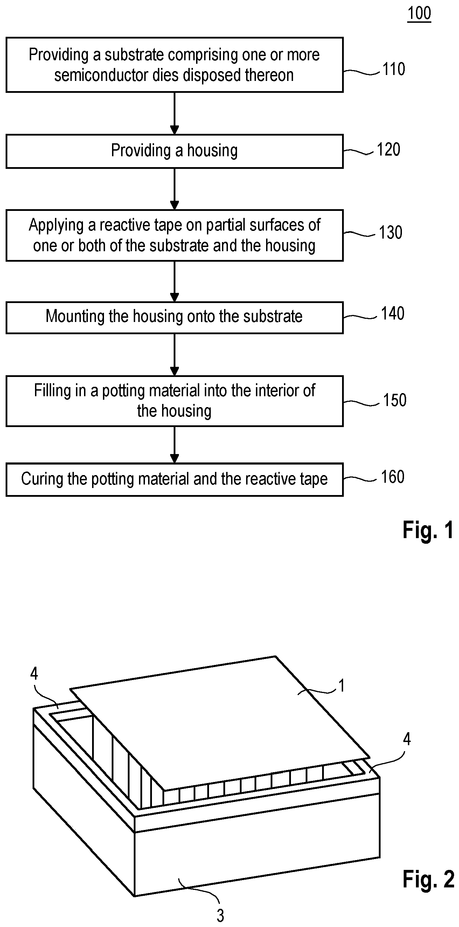

Fig. 1 shows a flow diagram for illustrating a method for fabricating a semiconductor device module.

The flow diagram 10 of Fig. 1 shows a method comprising providing a substrate comprising one or more semiconductor dies disposed thereon (11), providing a housing (12), applying a reactive tape on partial surfaces of one or both of the substrate and the housing (13), mounting the housing onto the substrate (14), filling in a potting material into the interior of the housing (15), and curing the potting material and the reactive tape (16).

Here it is important that curing is to be understood as a joint curing of the potting material and filler and the reactive tape. Only one such joint curing is performed.

Fig. 2 shows a perspective view on a semiconductor device module in an intermediate state of the fabrication, namely after providing a substrate 1 with semiconductor dies 2 disposed on a surface thereof and a housing 3. The semiconductor dies 2 are not to be seen, only the vertical pins extending from the semiconductor dies 2 in the direction of the opposing side of the housing 3 are to be seen in Fig. 2. The housing 3 is open on the upper side of the representation of Fig. 2, but comprises a circumferential edge which serves as a mounting surface for the substrate. On this circumferential edge the reactive tape 4 is applied. Alternatively the reactive tape 4 can also be applied onto a circumferential edge region of the substrate which is to be attached to the circumferential edge of the house.

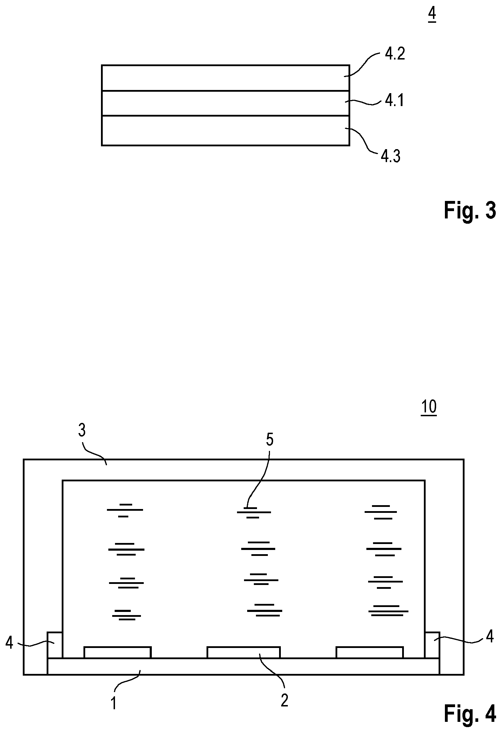

The reactive tape 4 is shown in further detail in Fig. 3. The reactive tape 4 comprises an inner solid glue layer 4.1 and two protective layers 4.2 and 4.3 covering the inner layer 4.1 on both opposing sides. The inner solid glue layer 4.1 can be based on an epoxy resin and in particular needs no separate thermal curing step for sealing. The reactive tape 4 has the advantage of a tape before curing and the advantages of currently used, viscous glue materials during and after the curing process. Such reactive tapes are commercially available and used e.g. in display manufacturing.

The double-sided reactive tape 4 is configured to seal against the highly viscous potting material in a semiconductor power module without an additional curing step. The reactive tape 4 cures in the curing process of the potting material and leads to a durable bonding with an even gap where no spacer is needed. The reactive tape 4 will also prevent leaking glue.

A thickness of the solid glue layer 4.1 can be in a range from 0.5 mm to 1.5 mm.

According to an embodiment of the method of the first aspect, the materials of the potting material 5 and the reactive tape 4 are selected such that they start to react at essentially one and the same temperature when curing them which means that they cure at approximately the same temperature. According to an example thereof, this temperature is in a range from 90°C to 120°C.

According to an embodiment of the method of the first aspect, the potting material comprises a viscoelastic material. According to an example thereof the viscoelastic material comprises one or more of a polymer, an amorphous polymer, a semicrystalline polymer, a biopolymer, a silicone, and a gel.

According to an embodiment of the method of the first aspect, the method further comprises performing a surface treatment of one or both of the surfaces of the substrate and the housing before applying the reactive tape. According to an example thereof, performing the surface treatment is done in such a way that the surface energy is reduced below a value of 35 mN/m.

According to a further example, performing the surface treatment is done by one or more of cleaning, milling, or exposing the surface to a plasma.

For further explanation it should be stated that the reactive tape 4 requires clean surfaces and a minimum surface energy (in this case determined to be about 34 mN/m) - like in every other glue bonding - to adhere to the substrates. After applying the reactive tape 4 it instantly leads to a bonding which can withstand small forces in the process: handling the modules on housing would be a safe process and it seals against the new potting material which in the present case is a certain gel with the product name KE-1070 from the company Shin-Etsu.

Pretests on a specific module of the Applicant with a milled glue surface have shown that sealing with the reactive tape 4 was essentially successful. The surface energy of the milled surface was below 30 mN/m (minimum requirement for good adhesion is 34mN/m). This can be easily further optimized by a proper surface modification (and even more with a surface pretreatment like plasma).

In the following process of curing, the reactive tape 4 reacts (starting at temperatures above 100°C) and leads to a long term and durable bonding. The investigated reactive tape 4 is based on an Epoxy and withstands corrosive gases. A fast disaster check with sulfide with the specific module has shown no discoloration of the copper surface of the substrate. Therefore there will be no need to use two different glue materials. Using the tape would make an additional heating step for the adhesive needless.

Fig. 4 shows a cross-sectional side view of a semiconductor device module after completing the fabrication process.

The semiconductor device module 10 of Fig. 4 comprises a substrate 1 comprising one or more semiconductor dies 2 disposed thereon, a housing 3 mounted on the substrate 1, an adhesive layer 4 disposed between partial surfaces of the substrate 1 and the housing 3, wherein the adhesive layer 4 is fabricated as was described before by applying a reactive tape 4 on one or both of the partial surfaces of the substrate 1 and the housing 3 and curing the reactive tape 4, a potting material 5 filled into the interior of the housing 3.

According to an embodiment of the semiconductor device module 10, the potting material 5 comprises a viscoelastic material. According to an example thereof, the viscoelastic material comprises one or more of a polymer, an amorphous polymer, a semicrystalline polymer, a biopolymer, a silicone, and a gel.

According to an embodiment of the semiconductor device module 10, a thickness of the adhesive layer 4 is in a range from 0.5 mm to 1.5 mm.

Further embodiments of the semiconductor device module 10 of Fig. 4 can be formed with any one of the features or embodiments which were shown and described above in connection with the method for fabricating a semiconductor device module.

### EXAMPLES

In the following specific examples of the present disclosure are described.

Example 1 is a method for fabricating a semiconductor device module, the method comprising providing a substrate comprising one or more semiconductor dies disposed thereon, providing a housing, applying a reactive tape on partial surfaces of one or both of the substrate and the housing, mounting the housing onto the substrate, filling in a potting material into the interior of the housing, and curing the potting material and the reactive tape.

Example 2 is the method according to Example 1, wherein the reactive tape is based on an epoxy material.

Example 3 is the method according to Example 1 or 2, wherein the materials of the potting material and the reactive tape are selected such that they start to react at essentially one and the same temperature when curing them.

Example 4 is the method according to Example 3, wherein this temperature is in a range from 90°C to 120°C.

Example 5 is the method according to anyone of the preceding Examples, in which the potting material comprises a viscoelastic material.

Example 6 is the method according to Example 5, in which the viscoelastic material comprises one or more of a polymer, an amorphous polymer, a semicrystalline polymer, a biopolymer, a silicone, and a gel.

Example 7 is the method according to any one of the preceding Examples, further comprising performing a surface treatment of one or both of the surfaces of the substrate and the housing before applying the reactive tape.

Example 8 is the method according to Example 7, further comprising performing the surface treatment in such a way that the surface energy is reduced below a value of 35 mN/m.

Example 9 is the method according to Example 7 or 8, further comprising performing the surface treatment by one or more of cleaning, milling, or exposing the surface to a plasma.

Example 10 is the method according to any one of the preceding Examples, wherein the reactive tape comprises a solid glue layer which is covered with protective layers on both sides.

Example 11 is the method according to any one of the preceding Examples, wherein a thickness of the solid glue layer is in a range from 0.5 mm to 1.5 mm.

Example 12 is a semiconductor device module, comprising a substrate comprising one or more semiconductor dies disposed thereon, a housing mounted on the substrate, an adhesive layer disposed between partial surfaces of the substrate and the housing, wherein the adhesive layer is fabricated by applying a reactive tape on one or both of the partial surfaces and curing the reactive tape, and a potting material filled into the interior of the housing.

Example 13 is the semiconductor device module according to Example 12, in which the potting material comprises a viscoelastic material.

Example 14 is the semiconductor device module according to Example 13, in which the viscoelastic material comprises one or more of a polymer, an amorphous polymer, a semicrystalline polymer, a biopolymer, a silicone, and a gel.

Example 15 is the semiconductor device module according to Example 14, wherein a thickness of the adhesive layer is in a range from 0.5 mm to 1.5 mm.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a semiconductor device module, the method comprising
- providing a substrate comprising one or more semiconductor dies disposed thereon (110);
- providing a housing (120);
- applying a reactive tape on partial surfaces of one or both of the substrate and the housing (130);
- mounting the housing onto the substrate (140);
- filling in a potting material into the interior of the housing (150); and
- curing the potting material and the reactive tape (160).

2. The method (100) according to claim 1, wherein
the reactive tape is based on an epoxy material.

3. The method (100) according to claim 1 or 2, wherein
the materials of the potting material and the reactive tape are selected such that they start to react at essentially one and the same temperature when curing them.

4. The method (100) according to claim 3, wherein
this temperature is in a range from 90°C to 120°C.

5. The method (100) according to anyone of the preceding claims, in which
the potting material comprises a viscoelastic material.

6. The method (100) according to claim 5, in which the viscoelastic material comprises one or more of a polymer, an amorphous polymer, a semicrystalline polymer, a biopolymer, a silicone, and a gel.

7. The method (100) according to any one of the preceding claims, further comprising performing a surface treatment of one or both of the surfaces of the substrate and the housing before applying the reactive tape.

8. The method (100) according to claim 7, further comprising performing the surface treatment in such a way that the surface energy is reduce below a value of 35 mN/m.

9. The method (100) according to claim 7 or 8, further comprising
performing the surface treatment by one or more of cleaning, milling, or exposing the surface to a plasma.

10. The method (100) according to any one of the preceding claims, wherein
the reactive tape comprises a solid glue layer which is covered with protective layers on both sides.

11. The method (100) according to any one of the preceding claims, wherein
a thickness of the solid glue layer is in a range from 0.5 mm to 1.5 mm.

12. A semiconductor device module (10), comprising
- a substrate (1) comprising one or more semiconductor dies (2) disposed thereon;
- a housing (3) mounted on the substrate (1);
- an adhesive layer (4) disposed between partial surfaces of the substrate and the housing, wherein the adhesive layer (4) is fabricated by applying a reactive tape on one or both of the partial surfaces and curing the reactive tape; and
- a potting material (5) filled into the interior of the housing.

13. The semiconductor device module (10) according to claim 12, in which
the potting material (5) comprises a viscoelastic material.

14. The semiconductor device module (10) according to claim 13, in which
the viscoelastic material comprises one or more of a polymer, an amorphous polymer, a semicrystalline polymer, a biopolymer, a silicone, and a gel.

15. The semiconductor device module (10) according to any one of claims 12 to 14, wherein
a thickness of the adhesive layer (4) is in a range from 0.5 mm to 1.5 mm.
